# EUROPÄISCHE PATENTSCHRIFT

(11) **EP 2 876 232 B1**
(45) Veröffentlichungstag und Bekanntmachung des Hinweises auf die Patenterteilung: **19.04.2017**
(21) Anmeldenummer: 13194296.3
(22) Anmeldetag: 25.11.2013
(51) Int. Cl.: E04H 6/02, A61H 33/06, F24J 2/00, H01L 31/12, E04H 1/12, E04H 6/00

(54) **Modularer Unterstellplatz**
Modular covered parking space
Abri de voiture modulaire

(43) Veröffentlichungstag der Anmeldung: 27.05.2015
(73) Patentinhaber: energy-invest GmbH, 39042 Brixen (IT)
(72) Erfinder: Foppa, Andreas, 39042 Brixen (IT)
(74) Vertreter: 2s | ip Schramm Schneider Patentanwälte Rechtsanwälte

(56) Entgegenhaltungen:
- EP-A1- 1 548 207
- CN-A- 102 277 985
- DE-U1-202009 016 950
- DE-U1-202012 101 572
- US-A1- 2007 044 391

## Beschreibung

### Gebiet der Erfindung

Die Erfindung betrifft einen modularen Unterstellplatz, insbesondere für Fahrzeuge, insbesondere elektrisch betriebene Fahrzeuge, oder zur Verwendung als Sauna sowie ein Solarmodul zur Verwendung in einem erfindungsgemäßen modularen Unterstellplatz.

### Stand der Technik und Hintergrund der Erfindung

Aus dem Stand der Technik sind eine Vielzahl von verschiedenen Unterstellplatzkonstruktionen, insbesondere für Fahrzeuge bekannt, wie beispielsweise aus der DE 20 2005 008 189 U1, oder aus der DE 295 15 728 U1.

Unterstellplätze für Fahrzeuge werden meist als Carport bezeichnet und haben häufig den Zweck, für das Fahrzeug lediglich einen Schutz von oben zu gewährleisten. Solche Carports sind seitlich meist offen und bestehen nur aus einem Dach und einer Stützkonstruktion. So zeigt die DE 20 2005 008 189 U1 ein Carport mit einem Dach, das von insgesamt acht Pfosten getragen wird. Solche Carports haben allerdings den Nachteil, dass sie einerseits ausschließlich für das Unterstellen eines Fahrzeuges vorgesehen sind und andererseits, dass die Größe bzw. Breite des Carports nicht an individuelle Bedürfnisse anpassbar ist, wenn etwa mehrere Fahrzeuge oder mehrere unterschiedliche Fahrzeuge, etwa ein Automobil und ein Motorrad, untergestellt werden sollen.

Ein weiterer Nachteil besteht darin, dass die aus dem Stand der Technik bekannten Carports keine Mittel zur Verfügung stellen, um einen Stromspeicher eines elektrisch betriebenen Fahrzeuges aufladen zu können. Hierfür muss das Fahrzeug meist an einem Stromanschluss, beispielsweise eines benachbarten Wohnhauses angeschlossen werden. Der Carport muss, sofern man ein Aufladen eines Stromspeichers eines abgestellten Fahrzeuges wünscht, in der Nähe eines Stromanschlusses errichtet werden, was einen flexiblen Einsatz eines Carports hinsichtlich des Aufstellortes erheblich einschränkt.

Aus der US 2007/0044391 A1 ist eine Hütte bekannt, die aus Bodenmodulen, Seitenwandmodulen und Dachmodulen zusammengebaut werden kann. Der Zusammenbau der einzelnen Module erfolgt mit Verbindungsmittel.

Aus der DE 20 2009 016 950 U1 eine Behausung für Fahrzeuge bekannt, die eine integrierte Stromversorgung zum Aufladen eines Akkumulators eines in der Behausung abgestellten Fahrzeuges aufweist. Die Überdachungskonstruktion der Behausung weist Photovoltaikelemente auf, die mit einem Zwischenspeicher gekoppelt sind. Ferner weist die Behausung ein Stromeinspeisekabel auf, zum Anschluss an das Fahrzeug auf.

Aus der CN 102 277 985 A ist ein Gehäuse bekannt, dass aus einer Anzahl von Modulen zusammengesetzt ist. Das Dach des Gehäuses ist aus einer Anzahl von Solarmodulen zusammengesetzt. Die Seitwände des Gehäuses können ebenfalls aus einer Anzahl von Solarmodulen zusammengesetzt sein.

Aus der DE 20 2012 101 572 U1 ist eine Garage bekannt, wobei auf dem Dach eine Photovoltaikanlage aus einer Anzahl von Photovoltaikmodulen angeordnet ist.

### Aufgabe der Erfindung

Der Erfindung liegt daher die Aufgabe zugrunde, einen Unterstellplatz, insbesondere für Fahrzeuge, insbesondere elektrisch betriebene Fahrzeuge, bereitzustellen, der einerseits flexibel erweiterbar ist und andererseits eine insgesamt verbesserte Funktionalität bietet.

### Erfindungsgemäße Lösung

Diese Aufgabe wird erfindungsgemäß durch einen modularen Unterstellplatz, insbesondere für Fahrzeuge, nach dem unabhängigen Anspruch gelöst. Vorteilhafte Ausgestaltungen und Weiterbildungen der Erfindung sind in den abhängigen Ansprüchen angegeben.

Bereitgestellt wird demnach ein modularer Unterstellplatz, insbesondere für Fahrzeuge, bestehend aus Einzelmodulen, die mit Verbindungsmittel zum Unterstellplatz zusammenbaubar sind, wobei die Einzelmodule umfassen:
- eine Bodenplatte,
- zwei senkrecht auf der Bodenplatte anordenbare und mit der Bodenplatte verbindbare Seitenwände, und
- ein Dach, das auf den Seitenwänden aufliegt und mit den Seitenwänden verbindbar ist,
wobei
- die Bodenplatte eine Anzahl von Bodenplattenmodulen umfasst, die miteinander zu der Bodenplatte verbindbar sind.

Der Unterstellplatz ist dadurch gekennzeichnet, dass
- das Dach eine Anzahl von Solarmodulen umfasst, die miteinander zu dem Dach verbindbar sind, und
- in zumindest einem Bodenplattenmodul mindestens eine Induktionsspule mit dazugehöriger Elektronik integriert ist, wobei das Bodenplattenmodul eine Anschlusseinheit aufweist, über die die Induktionsspule mit den Solarmodulen koppelbar ist.

Durch Vorsehen bzw. Einsetzen zusätzlicher Bodenplattenmodule und zusätzlicher Solarmodule kann die Bodenplatte bzw. das Dach verbreitert werden, um so einen größeren Unterstellplatz, beispielsweise ein größeres Carport zu erhalten. Um einen größeren Unterstellplatz zu erhalten, müssen also lediglich zusätzliche Bodenplattenmodule und zusätzliche Solarmodule vorgesehen werden, ohne dass der bereits vorhandene Unterstellplatz vollständig ausgetauscht werden muss. Zudem kann dadurch der Unterstellplatz individuell an die unterzustellenden Fahrzeuge angepasst werden, was eine höhere Flexibilität hinsichtlich der Einsetzbarkeit des Unterstellplatzes gewährleistet.

Durch das Vorsehen der Solarmodule kann elektrischer Strom bereitgestellt werden, mit dem die Stromspeicher untergestellter Fahrzeuge aufgeladen werden können. Der erfindungsgemäße Unterstellplatz kann so autark betrieben werden, ohne dass Stromanschlüsse, etwa von benachbarten Gebäuden, benötigt werden. Der erfindungsgemäße Unterstellplatz kann so auch auf der "grünen Wiese" aufgestellt werden, um beispielsweise elektrisch angetriebene Fahrräder auch in abgelegenen Regionen, etwa in den Bergen unterzustellen und aufladen zu können.

Die Einzelmodule können ferner eine Rückwand umfassen, die eine Anzahl von Rückwandmodulen umfasst, die miteinander zur Rückwand verbindbar sind. Auch hier muss bei einer Vergrößerung des Unterstellplatzes lediglich die benötigte Anzahl von Rückwandmodulen in die Rückwand eingesetzt werden.

In einer vorteilhaften Ausgestaltung des erfindungsgemäßen Unterstellplatzes weisen die Solarmodule, die Bodenplattenmodule und die Rückwandmodule jeweils im Wesentlichen eine gleiche Breite auf. Wird beispielsweise ein Bodenplattenmodul zwischen bestehenden Bodenplattenmodulen eingesetzt, müssen lediglich die entsprechende Anzahl von Rückwandmodulen und Solarmodulen eingesetzt werden, die die gleiche Breite aufweisen, wie die eingesetzten Bodenplattenmodule.

In einer vorteilhaften Ausgestaltung der Erfindung umfassen die Einzelmodule ferner eine Stromspeichereinrichtung, die mit den Solarmodulen koppelbar ist und die mit der von den Solarmodulen bereitgestellten elektrischen Energie aufladbar ist. Damit können untergestellte und elektrisch betriebene Fahrzeuge, beispielsweise elektrisch betriebene Fahrräder auch nachts aufgeladen werden, indem nachts der für das Aufladen benötigte Strom von der Stromspeichereinrichtung bezogen werden kann. Bei Sonnenschein können untergestellte elektrisch betriebene Fahrzeuge direkt mit dem von den Solarmodulen gewonnenen elektrischen Strom aufgeladen werden.

Vorzugsweise weist der erfindungsgemäße Unterstellplatz Lademittel auf, die mit den Solarmodulen und/oder mit der Stromspeichereinrichtung gekoppelt sind und die an zumindest einer Seitenwand und/oder an der Rückwand und/oder an oder in der Bodenplatte angeordnet sind und für ein Aufladen eines Stromspeichers zumindest eines elektrisch betriebenen Fahrzeuges vorgesehen sind.

Die Lademittel können zumindest eine Steckdose oder zumindest eine Steckdosenleiste und/oder zumindest eine Induktionsspule, die mit einer Sekundärspule eines elektrisch betriebenen Fahrzeuges zusammenwirken kann, umfassen.

In einer Ausgestaltung der Erfindung ist über die Anschlusseinheit des Bodenplattenmoduls die Induktionsspule mit der Stromspeichereinrichtung koppelbar.

Ein eingesetztes Bodenplattenmodul muss lediglich über die Anschlusseinheit mit den Solarmodulen bzw. mit der Stromspeichereinrichtung verbunden werden. Weitere Maßnahmen sind nicht mehr notwendig, um ein induktives Laden eines elektrisch betriebenen Fahrzeuges zu gewährleisten. Der Aufwand für das Erweitern eines erfindungsgemäßen Unterstellplatzes wird dadurch erheblich reduziert.

In einer Ausgestaltung der Erfindung ist in zumindest einem Rückwandmodul mindestens eine Steckdose oder Steckdosenleiste integriert, wobei das Rückwandmodul eine Anschlusseinheit aufweist, über die die Steckdose oder Steckdosenleiste mit den Solarmodulen und/oder mit der Stromspeichereinrichtung koppelbar ist. Auch hier muss nach dem Einsetzen eines Rückwandmoduls dieses lediglich über die Anschlusseinheit an die Solarmodule bzw. an die Stromspeichereinrichtung angeschlossen werden, um eine zusätzliche Lademöglichkeit für ein zusätzliches untergestelltes elektrisch betriebenes Fahrzeug zu ermöglichen.

In einer Ausgestaltung der Erfindung umfasst ein Solarmodul eine Anzahl von photovoltaischen Zellen, die von einem zumindest teilweise umlaufenden Rahmen gehaltert werden, wobei an der Rückseite der photovoltaischen Zellen (die Rückseite ist jene Seite, die nicht der Sonne zugewandt ist) und vorzugsweise beabstandet zu den photovoltaischen Zellen ein Leuchtmittel und/oder ein Heizmittel angeordnet ist. Damit kann der Unterstellplatz ausgeleuchtet und/oder beheizt werden.

Vorzugsweise werden die Leuchtmittel und/oder die Heizmittel von dem zumindest teilweise umlaufenden Rahmen gehaltert.

In einer Ausgestaltung der Erfindung umfassen die Leuchtmittel eine Anzahl von LED's und/oder eine Flächenbeleuchtung. Die Heizmittel können Infrarot-Paneele umfassen.

In einer besonderen Ausgestaltung der Erfindung kann in dem Rahmen ein Stromspeicher angeordnet sein, der mit den photovoltaischen Zellen und mit dem Leuchtmittel und/oder mit dem Heizmittel gekoppelt ist. Damit können die Leuchtmittel und/oder die Heizmittel auch ohne zusätzliche Stromspeichereinrichtung betrieben werden, wenn der Unterstellplatz beispielsweise als Wartebereich für eine Bushaltestelle verwendet wird. Durch die Integration des Stromspeichers in den Rahmen können die Leuchtmittel und/oder die Heizmittel auch nachts betrieben werden.

In einer weiteren besonderen Ausgestaltung des erfindungsgemäßen Unterstellplatzes können in dem Rahmen LED's angeordnet sein, dessen Licht seitlich in eine Glasscheibe, vorzugsweise Acrylglasscheibe, einkoppelbar ist. Die Glasscheibe ist vorzugsweise so ausgestaltet, dass eine gleichmäßige Streuung des eingekoppelten Lichts über die gesamte Fläche der Glasscheibe ermöglicht ist. Beispielsweise kann die Glasscheibe eine entsprechend bearbeitete Oberfläche aufweisen.

An den Seitenwänden des erfindungsgemäßen Unterstellplatzes können Werbeflächen angeordnet sein, die beispielsweise mit einer Hintergrundbeleuchtung versehen sind oder die als aktive Anzeigeeinrichtungen, etwa ein großes Display, ausgestaltet sind. Die Hintergrundbeleuchtung bzw. das Display kann mit dem von den Solarmodulen bereitgestellten elektrischen Strom bzw. mit dem in der Stromspeichereinrichtung gespeicherten elektrischen Strom betrieben werden.

In einer Ausgestaltung der Erfindung kann die Vorderseite des Unterstellplatzes eine Glasscheibe bzw. eine Glasfront aufweisen, die vorzugsweise vollständig geschlossen ist. In dieser Ausgestaltung kann an einer Seitenwand eine Tür vorgesehen sein, durch die der Unterstellplatz begehbar ist. Im Innenraum des begehbaren Unterstellplatzes mit der Frontscheibe kann ein Elektroofen vorgesehen sein, der mit der elektrischen Energie der Solarmodule und/oder mit der elektrischen Energie der Stromspeichereinrichtung mit Strom versorgt wird. Die Seitenwände und die Bodenplatte können mit Holzpaneelen ausgekleidet sein. Der modulare Unterstellplatz kann so als modulare Sauna bzw. Saunaeinrichtung verwendet werden, die eine Glasfront aufweist und die autark mit Energie versorgt wird. Die Sauna kann als Außensauna, etwa eines Hotels vorgesehen sein. Die in einer Seitenwand vorgesehene Tür kann als Verbindungstür zwischen dem Hotelgebäude und der Sauna vorgesehen sein.

### Kurzbeschreibung der Figuren

Weitere Einzelheiten und Merkmale der Erfindung sowie konkrete Ausführungsbeispiele der Erfindung ergeben sich aus der nachfolgenden Beschreibung in Verbindung mit der Zeichnung. Es zeigt:
- Fig. 1: eine perspektivische Ansicht eines erfindungsgemäßen Unterstellplatzes in einer modularen Bauweise;
- Fig. 2: einen Querschnitt eines erfindungsgemäßen Solarmoduls mit einem Leuchtmittel; und
- Fig. 3: einen Querschnitt eines erfindungsgemäßen Solarmoduls mit einem Heizmittel.

### Detaillierte Beschreibung der Erfindung

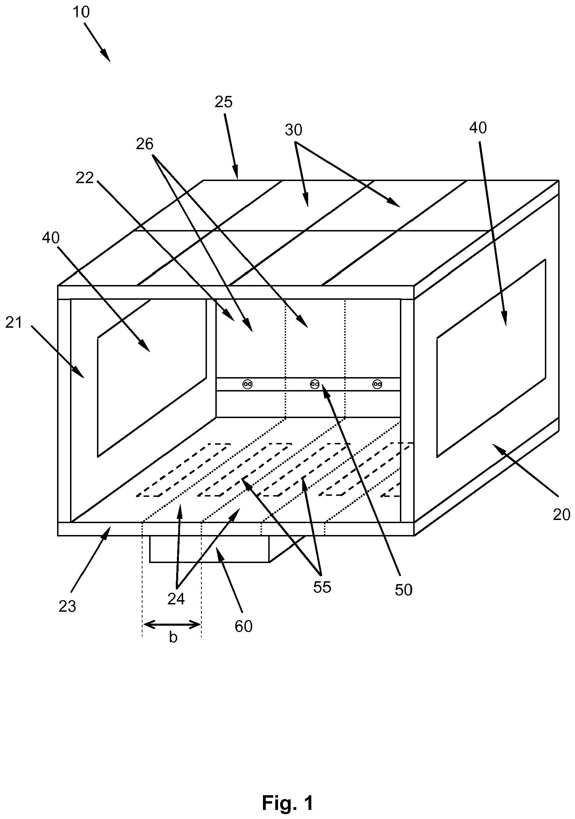

**Fig. 1** zeigt eine perspektivische Ansicht eines erfindungsgemäßen modularen Unterstellplatzes 10.

Der Unterstellplatz 10 umfasst eine Anzahl von Einzelmodulen, die mit geeigneten Verbindungsmitteln zusammengesetzt bzw. zusammengebaut werden. In der in Fig. 1 gezeigten Ausführungsform umfassen die Einzelmodule eine rechte Seitenwand 20, eine linke Seitenwand 21, eine Rückwand 22, eine Bodenplatte 23 sowie ein Dach 25. In einer Ausgestaltung der Erfindung kann auf die Rückwand 22 auch verzichtet werden.

Die Seitenwände 20, 21 sind in der hier gezeigten Ausführungsform als vollflächige Wände ausgestaltet. Sie können aber auch Ausnehmungen bzw. Aussparungen, beispielsweise Fenster oder Türen aufweisen. Die Seitenwände 20, 21 und/oder die Rückwand 22 kann aus Beton oder einem Metall, beispielsweise aus Aluminium, hergestellt sein. Besonders bevorzugt kann für die Seitenwände 20, 21 bzw. für die Rückwand 22 ein pulverbeschichtetes Aluminiumblech aus unterschiedlichen Farbtönen verwendet werden.
An den Seitenwänden 20, 21 können Werbeflächen 40 angeordnet sein, wobei die Werbeflächen sowohl außenliegend als auch innenliegend angeordnet werden können. Als Werbeflächen können beispielsweise bedruckte Plakate mit einer Hintergrundbeleuchtung oder aktive Werbeflächen, beispielsweise Werbedisplays, vorgesehen sein.

Die Bodenplatte 23 besteht aus einer Anzahl von Bodenplattenmodulen 24, die vorzugsweise jeweils die gleiche Breite b und die gleiche Tiefe aufweisen. Durch Aneinanderreihen einer Anzahl von Bodenplattenmodulen 24 kann die Bodenplatte 23 hergestellt werden. Die Bodenplattenmodule 24 können beispielsweise über eine Feder-Nut-Verbindung oder über eine Schwalbenschwanzverbindung zusammengefügt werden.

In ähnlicher Weise wird die Rückwand 22 durch eine Anzahl von Rückwandmodulen 26 gebildet, wobei auch die Rückwandmodule 26 mit geeigneten Verbindungsmitteln zusammengefügt werden.

Das Dach 25 umfasst eine Anzahl von Solarmodulen 30, die ebenfalls über geeignete Verbindungsmittel zusammengefügt werden. Das Dach 25 bzw. die Solarmodule 30 sind in Richtung zur Rückwand 22 leicht geneigt angeordnet, damit Regenwasser nach hinten abfließen kann. An der Rückseite des Unterstellplatzes kann hierzu eine Regenrinne vorgesehen sein.

Die Solarmodule 30 erzeugen elektrischen Strom, mit dem in dem Unterstellplatz untergestellte elektrisch betriebene Fahrzeuge aufgeladen werden können. Zum Aufladen untergestellter elektrisch betriebener Fahrzeuge weist der erfindungsgemäße Unterstellplatz eine Anzahl von Lademittel auf. Nicht erfindungsgemäß können an der Rückwand 22 eine Anzahl von Steckdosen bzw. eine Steckdosenleiste vorgesehen sein, die mit den Solarmodulen 30 gekoppelt sind. Erfindungsgemäß sind in der Bodenplatte 23 eine Anzahl von Induktionsspulen 55 vorgesehen , die ebenfalls mit den Solarmodulen 30 gekoppelt sind.

Um auch bei schlechten Lichtverhältnissen bzw. bei Nacht ein Aufladen elektrisch betriebener Fahrzeuge zu ermöglichen, ist es vorteilhaft, wenn der Unterstellplatz zusätzlich eine Stromspeichereinrichtung 60, beispielsweise einen Akkumulator, vorsieht. Die Stromspeichereinrichtung 60 ist sowohl mit den Solarmodulen 30 gekoppelt, um mit der von den Solarmodulen 30 bereitgestellten elektrischen Energie die Stromspeichereinrichtung 60 aufzuladen, als auch mit der Steckdosenleiste 50 bzw. mit den Induktionsspulen 55 gekoppelt. Bei schlechten Lichtverhältnissen bzw. bei Nacht kann die für das Aufladen elektrisch betriebener Fahrzeuge benötigte elektrische Energie von der Stromspeichereinrichtung 60 bezogen werden.

Die Stromspeichereinrichtung 60 kann in die Bodenplatte 23 integriert sein oder, wie in Fig. 1 gezeigt, unterhalb der Bodenplatte angeordnet sein.
In die Bodenplattenmodule 24 sind jeweils eine Anzahl von Induktionsspulen mit der dazugehörigen Elektronik integriert. Die Bodenplattenmodule 24 weisen jeweils eine Anschlusseinheit auf, über die die Induktionsspulen bzw. die Elektronik mit den Solarmodulen 30 bzw. mit der Stromspeichereinrichtung 60 gekoppelt werden können. Dadurch kann der erfindungsgemäße Unterstellplatz auf einfache Weise erweitert werden, wobei durch Einsetzen eines zusätzlichen Bodenplattenmoduls 24 gleichzeitig die Möglichkeit geschaffen wird, ein zusätzliches elektrisch betriebenes Fahrzeug induktiv aufzuladen (d.h. das oder die untergestellten elektrisch betriebenen Fahrzeuge können drahtlos aufgeladen werden). Die Bodenplattenmodule 24 können vollständig werkseitig hergestellt werden, sodass bei der Herstellung des Unterstellplatzes die Bodenplattenmodule lediglich zusammengefügt und angeschlossen werden müssen.

In die Rückwandmodule 26 können ebenfalls die Steckdosen bzw. Steckdosenleisten 50 integriert sein, sodass auch die Rückwandmodule 26 werkseitig vollständig hergestellt werden können. Die Rückwandmodule weisen ebenfalls Anschlussmittel auf, um die Rückwandmodule bzw. die Steckdosen und/oder Steckdosenleisten mit den Solarmodulen 30 bzw. mit der Stromspeichereinrichtung 60 zu verbinden. Die Bodenplattenmodule 24, die Rückwandmodule 26 und die Solarmodule 30 weisen jeweils vorzugsweise die gleiche Breite b auf, sodass bei einem Anpassen der Größe des Unterstellplatzes 10 jeweils die gleiche Anzahl der entsprechenden Module eingesetzt bzw. entfernt werden können.
Selbstverständlich können die vorgesehenen Lademittel 50, 55 bzw. zusätzliche Lademittel vorgesehen sein, um auch andere elektrische Geräte, beispielsweise ein Mobiltelefon kabelgebunden oder kabellos aufzuladen.

In einer alternativen nicht erfindungsgemäßen Ausgestaltung kann auf die Lademittel 50, 55 verzichtet werden, sodass der erfindungsgemäße Unterstellplatz 10 beispielsweise auch als Wartebereich beispielsweise für eine Bushaltestelle verwendet werden kann.
An der Unterseite der Solarmodule 30 kann eine Beleuchtung oder eine Heizung vorgesehen sein, die entweder direkt von den Solarmodulen oder von der Stromspeichereinrichtung 60 mit elektrischer Energie versorgt werden.
Damit wird ein modularer Unterstellplatz bereitgestellt, der durch Einsetzen bzw. Entfernen entsprechender Rückwandmodule, Bodenplattenmodule und Solarmodule vergrößert bzw. verkleinert werden kann und so besonders einfach an unterschiedliche Bedürfnisse anpassbar ist. Gleichzeitig ist gewährleistet, dass untergestellte elektrisch betriebene Fahrzeuge, beispielsweise E-Bikes, Elektroroller oder elektrisch angetriebene PKWs aufgeladen werden können, auch wenn keine externe Stromversorgung zur Verfügung steht.

Damit eignen sich erfindungsgemäße Unterstellplätze insbesondere in Gebieten, wo keine Stromversorgung vorhanden ist, beispielsweise im Gebirge. Zudem muss beim Herstellen bzw. Aufbauen eines erfindungsgemäßen Unterstellplatzes keine Rücksicht darauf genommen werden, ob eine externe Stromversorgung zur Verfügung steht, sodass ein erfindungsgemäßer Unterstellplatz, da er vollständig autark betrieben werden kann, an jedem beliebigen Platz aufgestellt werden kann.

In einer Ausgestaltung der Erfindung kann der modulare Unterstellplatz auch als Sauna bzw. Außensauna verwendet werden. Hierzu ist an der Vorderseite des Unterstellplatzes eine Glasscheibe angeordnet bzw. ist die Vorderseite mit einer Glasscheibe verschlossen. An einer Seitenwand oder an der Rückwand kann eine Tür vorgesehen sein, durch die die Sauna betreten werden kann. Der Innenraum des Unterstellplatzes kann mit Holz bzw. Holzpaneelen verkleidet sein. Im Innenraum kann ein Elektroofen vorgesehen sein, der mit den Solarmodulen und/oder mit der Stromspeichereinrichtung gekoppelt ist, um den Elektroofen mit elektrischer Energie zu versorgen.

Durch die Solarmodule 30 und/oder durch die Stromspeichereinrichtung 60 kann die Sauna als autarke Sauna, d.h. ohne externe Energieversorgung betrieben werden.

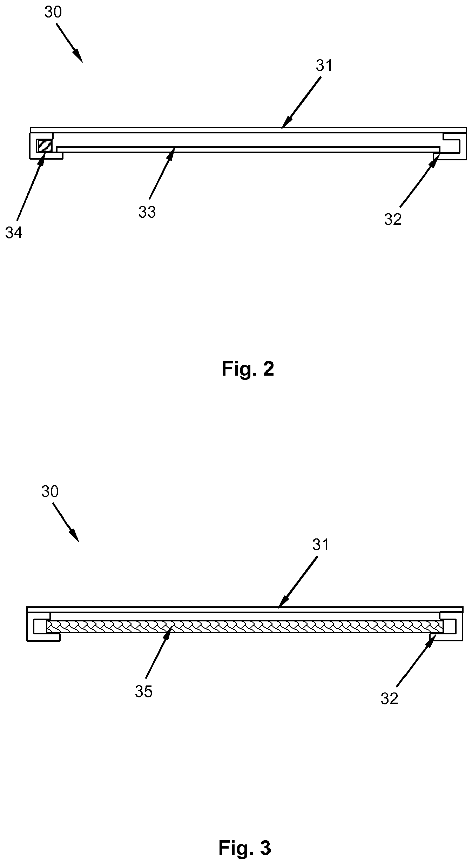

**Fig. 2** zeigt einen Querschnitt eines erfindungsgemäßen Solarmoduls 30, das zur Herstellung eines Daches eines erfindungsgemäßen Unterstellplatzes verwendet werden kann.

Das in Fig. 2 gezeigte Solarmodul 30 umfasst eine Anzahl von photovoltaischen Zellen 31, die von einem zumindest teilweise umlaufenden Rahmen 32 gehaltert werden. Der Rahmen 32 kann beispielsweise aus Aluminium hergestellt sein. An der Rückseite der photovoltaischen Zellen 31, d.h. an der Seite, die nicht dem Sonnenlicht zugewandt ist, kann ein Leuchtmittel 33 vorgesehen sein, das wiederum von dem umlaufenden Rahmen 32 gehaltert wird.

Mit einer Anzahl solcher Solarmodule 30 kann auf besonders einfache Art und Weise ein Dach eines erfindungsgemäßen Unterstellplatzes hergestellt werden, das einerseits elektrischen Strom zum Aufladen elektrisch betriebener Fahrzeuge bereitstellt und andererseits den Innenbereich des Unterstellplatzes ausleuchtet. Die elektrische Energie für den Betrieb des Leuchtmittels 33 kann direkt von den photovoltaischen Zellen 31 bereitgestellt werden, oder falls die von den photovoltaischen Zellen 31 bereitgestellte elektrische Energie nicht ausreicht von der Energiespeichereinrichtung 60 bezogen werden.

In einer alternativen Ausgestaltung eines erfindungsgemäßen Solarmoduls 30 kann in dem Rahmen 32 ein eigener Energiespeicher vorgesehen sein, der von den photovoltaischen Zellen 31 aufgeladen wird und der beispielsweise nachts die elektrische Energie für das Leuchtmittel 33 zur Verfügung stellt. Damit kann das Leuchtmittel 33 auch dann betrieben werden, wenn an dem Unterstellplatz 10 keine Energiespeichervorrichtung 60 vorgesehen ist. Dies ist insbesondere dann vorteilhaft, wenn der erfindungsgemäße Unterstellplatz 10 beispielsweise als Wartehäuschen einer Bushaltestelle verwendet wird, wo lediglich ausreichend elektrische Energie für den Betrieb der Leuchtmittel 33 bereitgestellt werden muss. In dem umlaufenden Rahmen 32 können Anschlussmittel vorgesehen sein, über die mehrere Solarmodule miteinander gekoppelt werden können. Ebenso können in dem umlaufenden Rahmen 32 auch Anschlüsse vorgesehen sein, mit denen die photovoltaischen Zellen 31 zweier gekoppelter Solarmodule in Serie geschaltet werden können.

Als Leuchtmittel 33 können beispielsweise eine Anzahl von lichtemittierenden Dioden (LED's) oder eine Flächenbeleuchtung vorgesehen sein. In einer Ausgestaltung des Solarmoduls 30 können in dem umlaufenden Rahmen 32 eine Anzahl von LED's angeordnet sein, dessen Licht randseitig in eine vom Rahmen 32 gehalterte Glasplatte eingekoppelt wird. Die Glasplatte ist vorzugsweise so ausgestaltet, dass das randseitig eingekoppelte Licht über die gesamte Glasfläche gleichmäßig gestreut bzw. ausgekoppelt wird. Als Glasplatte kann beispielsweise eine Acrylglasscheibe vorgesehen sein, dessen Oberfläche entsprechend aufgeraut ist, um ein gleichmäßiges Streuen des eingekoppelten Lichtes zu gewährleisten.

**Fig. 3** zeigt eine alternative Ausgestaltung eines Solarmoduls 30, wobei anstelle des in Fig. 2 gezeigten Leuchtmittels 33 eine Heizeinrichtung 35 vorgesehen ist. Die Heizeinrichtung 35 kann beispielsweise als Infrarot-Panel ausgestaltet sein, die im Betrieb Wärmestrahlung nach unten abgibt. Die Heizmittel 35 können entweder direkt über die photovoltaischen Zellen 31 oder über die Energiespeichereinrichtung 60 oder über einen im umlaufenden Rahmen 32 angeordneten Energiespeicher 34 mit elektrischem Strom versorgt werden.

Die in Fig. 2 und Fig. 3 gezeigten Ausgestaltungen eines erfindungsgemäßen Solarmoduls können auch kombiniert werden, sodass ein Solarmodul 30 eine Anzahl von Leuchtmitteln und eine Anzahl von Heizeinrichtungen aufweist.

Die Verwendung eines Solarmoduls gemäß Fig. 3 ist insbesondere dann vorteilhaft, wenn der erfindungsgemäße modulare Unterstellplatz beispielsweise als Wartehäuschen einer Bushaltestelle verwendet wird.

### Bezugszeichen:

- 10: Mobiler, modularer Unterstand
- 20: rechte Seitenwand
- 21: linke Seitenwand
- 22: Rückwand
- 23: Boden bzw. Bodenplatte
- 24: Bodenplattenmodule
- 25: Dach
- 26: Rückwandmodule
- 30: Solarmodule
- 31: Photovoltaische Zellen
- 32: zumindest teileweise umlaufender Rahmen (z.B. aus Aluminium)
- 33: Leuchtmittel (z.B. LEDs oder Flächenbeleuchtung)
- 34: Stromspeicher für Leuchtmittel und/oder LEDs, dessen Licht seitlich in das Leuchtmittel 33 (z.B. Acrylglasscheibe) eingekoppelt wird
- 35: Heizmittel (z.B. IR-Paneele)
- 40: Werbeflächen (bedruckt mit Hintergrundbeleuchtung oder aktive Anzeigeeinrichtung (z.B. Monitor))
- 50: Lademittel (Steckdosenleiste)
- 55: Lademittel (Induktionsspulen)
- 60: Stromspeichereinrichtung (z.B. Akkumulator)

## Patentansprüche

1. Modularer Unterstellplatz (10), insbesondere für Fahrzeuge, bestehend aus Einzelmodulen, die mit Verbindungsmittel zu dem Unterstellplatz zusammenbaubar sind, wobei die Einzelmodule umfassen:
- eine Bodenplatte (23),
- zwei senkrecht auf der Bodenplatte anordenbare und mit der Bodenplatte verbindbare Seitenwände (20; 21), und
- ein Dach (25), das auf den Seitenwänden (20; 21) aufliegt und mit den Seitenwänden verbindbar ist,
wobei die Bodenplatte eine Anzahl von Bodenplattenmodulen (24) umfasst, die miteinander zu der Bodenplatte verbindbar sind,
**dadurch gekennzeichnet, dass**
- das Dach (25) eine Anzahl von Solarmodulen (30) umfasst, die miteinander zu dem Dach verbindbar sind, und
- in zumindest einem Bodenplattenmodul (24) mindestens eine Induktionsspule mit dazugehöriger Elektronik integriert ist, wobei das Bodenplattenmodul eine Anschlusseinheit aufweist, über die die Induktionsspule mit den Solarmodulen (30) koppelbar ist.

2. Unterstellplatz (10) nach Anspruch 1, wobei die Einzelmodule ferner eine Rückwand (22) umfassen, die eine Anzahl von Rückwandmodulen (26) umfasst, die miteinander zu der Rückwand verbindbar sind.

3. Unterstellplatz (10) nach einem der vorhergehenden Ansprüche, wobei die Solarmodule (30), die Bodenplattenmodule (24) und die Rückwandmodule (26) jeweils im Wesentlichen eine gleiche Breite (b) aufweisen.

4. Unterstellplatz (10) nach einem der vorhergehenden Ansprüche, wobei die Einzelmodule ferner eine Stromspeichereinrichtung (60) umfassen, die mit den Solarmodulen (30) koppelbar ist und die mit der von den Solarmodulen (30) bereitgestellten elektrischen Energie aufladbar ist.

5. Unterstellplatz (10) nach einem der vorhergehenden Ansprüche, wobei der Unterstellplatz Lademittel (50; 55) umfasst, die mit den Solarmodulen (30) und/oder mit der Stromspeichereinrichtung (60) gekoppelt sind und die an zumindest einer Seitenwand (20; 21) und/oder an der Rückwand (22) und/oder an oder in der Bodenplatte (23) angeordnet sind und für ein Aufladen eines Stromspeichers zumindest eines elektrisch betriebenen Fahrzeuges vorgesehen sind.

6. Unterstellplatz (10) nach Anspruch 5, wobei die Lademittel zumindest eine Steckdose oder zumindest eine Steckdosenleiste (50) und/oder zumindest eine Induktionsspule, die mit einer Sekundärspule eines elektrisch betriebenen Fahrzeuges zusammenwirken kann, umfassen.

7. Unterstellplatz (10) nach Anspruch 6, wobei über die Anschlusseinheit des Bodenplattenmoduls die Induktionsspule mit der Stromspeichereinrichtung (60) koppelbar ist.

8. Unterstellplatz (10) nach Anspruch 6 oder 7, wobei in zumindest einem Rückwandmodul (26) mindestens eine Steckdose oder Steckdosenleiste (50) integriert ist und wobei das Rückwandmodul eine Anschlusseinheit aufweist, über die die Steckdose oder Steckdosenleiste mit den Solarmodulen (30) und/oder mit der Stromspeichereinrichtung (60) koppelbar ist.

9. Unterstellplatz (10) nach einem der vorhergehenden Ansprüche, wobei das Solarmodul (30) eine Anzahl von photovoltaischen Zellen (31) umfasst, die von einem zumindest teilweise umlaufenden Rahmen (32) gehaltert werden, wobei an der Rückseite der photovoltaischen Zellen und vorzugsweise beabstandet zu den photovoltaischen Zellen ein Leuchtmittel (33) und/oder ein Heizmittel (35) angeordnet ist.

10. Unterstellplatz (10) nach Anspruch 9, wobei die Leuchtmittel (33) eine Anzahl von LEDs und/oder eine Flächenbeleuchtung umfassen und/oder wobei die Heizmittel (35) Infrarot-Paneele umfassen.

11. Unterstellplatz (10) nach einem der Ansprüche 9 bis 10, wobei in dem Rahmen (32) ein Stromspeicher angeordnet ist, der mit den photovoltaischen Zellen (31) und mit dem Leuchtmittel (33) und/oder mit dem Heizmittel (35) gekoppelt ist.

12. Unterstellplatz (10) nach einem der Ansprüche 9 bis 11, wobei in dem Rahmen (32) LEDs angeordnet sind, dessen Licht seitlich in eine Glasscheibe, vorzugsweise Acrylglasscheibe, einkoppelbar ist.

13. Unterstellplatz (10) nach einem der vorhergehenden Ansprüche, wobei an der Vorderseite eine Glasscheibe oder eine Glasfront vorgesehen ist, wobei in dem Unterstellplatz ein Elektroofen angeordnet ist, der mit den Solarmodulen (30) und/oder mit der Stromspeichereinrichtung (60) gekoppelt ist, und wobei der Unterstellplatz zur Verwendung als Sauna oder Außensauna vorgesehen ist.

## Claims

1. A modular car shed (10), in particular for vehicles, consisting of individual modules which may be assembled using connecting means so as to form said car shed, the individual modules comprising:
- a base plate (23),
- two side walls (20; 21) that may be disposed on the base plate and connected with the base plate, and
- a roof (25) that rests on the side walls (20; 21) and is connectible with said side walls,
said base plate comprising a number of base plate modules (24) that may be interconnected so as to form the base plate,
**characterised in that**
- the roof (25) comprises a number of solar modules (30) that may be interconnected so as to form said roof, and
- at least one base plate module (24) incorporates at least one induction coil having associated electronics, said base plate module having a connection unit via which the induction coil may be coupled to the solar modules (30).

2. The car shed (10) as claimed in claim 1, wherein the individual modules further comprise a rear wall (22) that comprises a number of rear wall modules (26) which are interconnectable so as to form said rear wall.

3. The car shed (10) as claimed in any of the preceding claims, wherein the solar modules (30), the base plate modules (24), and the rear wall module (26) have each essentially an identical width (b).

4. The car shed (10) as claimed in any of the preceding claims, wherein the individual modules further comprise an energy storage device (60) that may be coupled to the solar modules (30) and may be charged by the electric energy that is provided by the solar modules (30).

5. The car shed (10) as claimed in any of the preceding claims, wherein said car shed comprises charging means (50; 55) that are coupled with the solar modules (30) and/or with the energy storage device (60) and are disposed on at least one side wall (20; 21) and/or on the rear wall (22) and/or on or in the base plate (23) and which are designed for charging an energy storage battery of at least one electrically powered vehicle.

6. The car shed (10) as claimed in claim 5, wherein the charging means comprise at least one power outlet or at least one power outlet strip (50) and/or at least one induction coil which may cooperate with a secondary coil of an electrically powered vehicle.

7. The car shed (10) as claimed in claim 6, wherein the induction coil may be coupled to the energy storage device (60) via the connection unit of the base plate.

8. The car shed (10) as claimed in claim 6 or 7, wherein the at least one rear wall module (26) incorporates at least one power outlet or power outlet strip (50) and wherein the rear wall module has a connection unit via which the power outlet or power outlet strip may be coupled to the solar modules (30) or to the energy storage device (60).

9. The car shed (10) as claimed in any of the preceding claims, wherein the solar module (30) comprises a number of photovoltaic cells (31) which are supported by an at least partially circumferential frame (32), a lighting means (33) and/or a heating means (35) being disposed on the rear side of the photovoltaic cells and preferably spaced apart from said photovoltaic cells.

10. The car shed (10) as claimed in claim 9, wherein the lighting means (33) comprise a number of LEDs and/or a surface lighting means and/or wherein the heating means (35) comprise infra-red panels.

11. The car shed (10) as claimed in any one of claims 9 to 10, wherein the frame (32) has an energy storage battery disposed therein which is coupled to the photovoltaic cells (31) and to the lighting means (33) and/or to the heating means (35).

12. The car shed (10) as claimed in any one of claims 9 to 11, wherein the frame (32) has LEDs disposed therein the light of which may be coupled laterally into a glass panel, preferably an acrylic glass panel.

13. The car shed (10) as claimed in any of the preceding claims, wherein a glass pane or a glass front is provided on the front side, wherein the car shed has an electric stove arranged therein which is coupled to the solar modules (30) and/or to the energy storage device (60), and wherein the car shed is designed for being used as a sauna or as an outdoor sauna.

## Revendications

1. Abri modulaire (10), en particulier pour véhicules, constitué de modules individuels qui peuvent être assemblés grâce à des moyens d'assemblage pour former ledit abri, les modules individuels comprenant :
- une plaque de fond (23),
- deux parois latérales (20; 21) qui peuvent être disposées de manière perpendiculaire sur la plaque de fond et qui peuvent être assemblées à ladite plaque de fond, et
- un toit (25) qui repose sur les parois latérales (20; 21) et qui peut être assemblé auxdites parois latérales,
la plaque de fond comprenant un nombre donné de modules de plaque de fond (24) qui peuvent être assemblés les uns aux autres pour former ladite plaque de fond,
**caractérisé en ce que**
- le toit (25) comprend un nombre donné de modules solaires (30) qui peuvent être assemblés les uns aux autres pour former ledit toit, et
- une bobine d'induction équipée de l'électronique correspondante est intégrée dans au moins un module de plaque de fond (24), le module de plaque de fond présentant une unité de raccordement grâce à laquelle la bobine d'induction peut être couplée aux modules solaires (30).

2. Abri (10) selon la revendication 1, dans lequel les modules individuels comprennent en outre une paroi arrière (22) qui comprend un nombre donné de modules de paroi arrière (26) qui peuvent être assemblés les uns aux autres pour former ladite paroi arrière.

3. Abri (10) selon l'une quelconque des revendications précédentes, dans lequel les modules solaires (30), les modules de plaque de fond (24) et les modules de paroi arrière (26) présentent, chacun, essentiellement une même largeur (b).

4. Abri (10) selon l'une quelconque des revendications précédentes, dans lequel les modules individuels comprennent en outre un dispositif accumulateur de courant (60) qui peut être couplé aux modules solaires (30) et qui peut être rechargé avec l'énergie électrique fournie par les modules solaires (30).

5. Abri (10) selon l'une quelconque des revendications précédentes, dans lequel ledit abri comprend des moyens de charge (50; 55) qui sont couplés aux modules solaires (30) et/ou au dispositif accumulateur de courant (60) et qui peuvent être disposés sur au moins une paroi latérale (20; 21) et/ou sur la paroi arrière (22) et/ou sur ou dans la plaque de fond (23) et qui sont prévus pour recharger un accumulateur de courant d'au moins un véhicule fonctionnant à l'électricité.

6. Abri (10) selon la revendication 5, dans lequel les moyens de charge comprennent au moins une prise de courant ou au moins un bloc multiprise (50) et/ou au moins une bobine d'induction qui est capable de coopérer avec une bobine secondaire d'un véhicule fonctionnant à l'électricité.

7. Abri (10) selon la revendication 6, dans lequel la bobine d'induction peut être couplée au dispositif accumulateur de courant (60) grâce à l'unité de raccordement du module de plaque de fond.

8. Abri (10) selon la revendication 6 ou 7, dans lequel au moins une prise de courant ou au moins un bloc multiprise (50) est intégré(e) dans au moins un module de paroi arrière (26), et dans lequel le module de paroi arrière présente une unité de raccordement grâce à laquelle la prise de courant ou le bloc multiprise peut être couplé(e) aux modules solaires (30) et/ou au dispositif accumulateur de courant (60).

9. Abri (10) selon l'une quelconque des revendications précédentes, dans lequel le module solaire (30) comprend un nombre donné de cellules photovoltaïques (31) qui sont maintenues par un cadre (32) qui les entoure au moins partiellement, un moyen d'éclairage (33) et/ou un moyen de chauffage (35) étant disposé(s) sur la face arrière des cellules photovoltaïques, et ce de préférence à une distance donnée par rapport auxdites cellules photovoltaïques.

10. Abri (10) selon la revendication 9, dans lequel les moyens d'éclairage (33) comprennent un nombre donné de DELs et/ou un éclairage de surface, et/ou dans lequel les moyens de chauffage (35) comprennent des panneaux infrarouges.

11. Abri (10) selon l'une quelconque des revendications 9 à 10, dans lequel un accumulateur de courant qui est couplé aux cellules photovoltaïques (31) et au moyen d'éclairage (33) et/ou au moyen de chauffage (35) est disposé dans le cadre (32).

12. Abri (10) selon l'une quelconque des revendications 9 à 11, dans lequel des DELs dont la lumière peut être insérée latéralement dans une plaque de verre, de préférence une plaque de verre acrylique, sont disposées dans le cadre (32).

13. Abri (10) selon l'une quelconque des revendications précédentes, dans lequel une plaque de verre ou une façade vitrée est prévue sur la face avant, dans lequel un four électrique qui est couplé aux modules solaires (30) et/ou au dispositif accumulateur de courant (60) est disposé dans ledit abri, et dans lequel ledit abri est prévu pour être utilisé en tant que sauna ou en tant que sauna extérieur.
